Europäisches Patentamt

(19) European Patent Office    (11) Publication number: **0 032 276**

Office européen des brevets    **B1**

(12)    **EUROPEAN PATENT SPECIFICATION**

(45) Date of publication of patent specification: **27.12.84**    (51) Int. Cl.³: **H 04 B 1/06,** H 03 J 7/32,
   G 01 R 23/16

(21) Application number: **80300018.1**

(22) Date of filing: **03.01.80**

(54) **Signal Processing Apparatus.**

(43) Date of publication of application:
   **22.07.81 Bulletin 81/29**

(45) Publication of the grant of the patent:
   **27.12.84 Bulletin 84/52**

(84) Designated Contracting States:
   **DE FR GB NL SE**

(56) References cited:
   **GB-A- 736 602**
   **US-A-2 882 395**
   **US-A-3 013 209**

   **MICROWAVE JOURNAL, vol. 17, no. 9,**
   **september 1974, Horizon House-Microwave**
   **Inc., Massachusetts, USA, J.B. HARRINGTON**
   **and R.B. NELSON, "Compressive intercept**
   **receiver uses SAW devices", pages 57-62**
   **MICROWAVE SYSTEM NEWS, October 1977,**
   **pages 85-92**

(73) Proprietor: **TYPALOGICS INC.**
   **1456 Cloverfield Boulevard**
   **Santa Monica, CA 90404 (US)**

(72) Inventor: **Ready, Patrick J.**
   **1456 Cloverfield Avenue**
   **Santa Monica California 90404 (US)**

(74) Representative: **Wilson, Joseph Martin et al**
   **WITHERS & ROGERS 4 Dyer's Buildings Holborn**
   **London EC1N 2JT (GB)**

Courier Press, Leamington Spa, England.

## Description

This invention relates to signal processing apparatus for analysing a band of input signals as from radio receiver circuitry.

There has long been a need for new receivers designed to monitor a selected frequency band, simultaneously perform spectral analysis of multiple signals appearing at unpredictable frequencies in the band and simultaneously coherently extract the multiple signals. A receiver which performs the first function, spectral analysis, is the compressive or microscan receiver. Such receivers are best described in the publications:

1. H. M. Gerard, O. W. Otto, "Chirp Transform Opens New Processing Possibilities", Microwave System News, pp. 85—92, October, 1977.
2. J. B. Harrington, R. B. Nelson, "Compressive Intercept Receiver Uses SAW Devices", Microwave Journal, pp. 57—62, 1974.

A conventional compressive receiver has frequency shifting means whereby the output from a swept or chirped local oscillator is mixed with a band of incoming signals to provide a frequency shift which varies as a function of time, and dispersive delay means such as a dispersive delay line or filter for delaying signals over a range of time delay values as a function of frequency. In this way, the receiver forms the analog Fourier transform of its input, with both amplitude and phase preserved prior to envelope detection. This transform is produced once per scan period ($T_s$) of the oscillator with a frequency resolution approximately

$$\frac{1}{T} Hz,$$

where T is the length of time a pure tone at the receiver input is visible to the compression filter. For conventional receivers $T_s > T$.

Typically, the fraction of sweep time ($T_s$) that a signal is visible to its compression filter, termed probability of intercept (POI) or duty cycle for a conventional compression receiver, is 0.5 or 50%. Only in limiting cases where the input bandwidth approaches 0 Hz or the scan rate R becomes infinite does the POI approach 1 or 100%. The end result has been that conventional receivers necessarily have scan rates which are too slow relative to the Nyquist criteria and channelization of signals is therefore prohibited.

A somewhat different approach has been taken by certain researchers employing conventional compression receivers in which the compression filter bandwidth and dispersion are twice that of the swept oscillator.

Such a configuration approaches minimum Nyquist sampling since $T=T_s$. However, each output pulse is located at a different intermediate frequency, corresponding to its initial location with the input bandwidth. Thus, side-lobe suppression in this system cannot be achieved by a passive IF filter, and the noise bandwidth is twice that required for the same resolution in the previous configuration. Additionally, simultaneous channelization of signals of interest (SOI) is not possible due to the random IF's.

As a final comment on the prior art, we note that it is not unusual to find a signal of interest in close frequency proximity to an unwanted strong emitter. Under these conditions, it is very likely that energy from this strong signal will be significant within the channelization filter centered on the signal of interest. Thus, in practical situations, it is important to have the receiver sampling rate significantly above Nyquist (say twice) to avoid folding the strong emitter directly onto the signals of interest. In systems of this type, replicating the receiver to provide parallel, time-sequential channels is required. This is a costly approach in terms of both hardware and the degree to which the multiple receivers must be matched.

According to one aspect of the invention there is provided signal processing apparatus for analysing a band of input signals as from radio receiver circuitry, the apparatus comprising frequency shifting means providing a frequency shift which varies as a function of time, said frequency shifting means comprising a variable frequency oscillation generator having a predetermined scan rate which is connected to an input of a first mixing means, and dispersive delay means for delaying signals over a range of time delay values as a function of frequency, the signal processing apparatus being characterised by the features claimed in the characterising portion of either claim 1 or claim 2. Such a signal processing apparatus, which is capable of both channelisation and improved frequency resolution, solves the problems of sampling rate and probability of intercept (POI) of the conventional receivers.

The apparatus can be incorporated in a radio receiver to provide both channelization and improved frequency resolution and to overcome the problems of sampling rate and POI encountered with the conventional receiver.

According to another aspect of the invention, a method of processing signals received in a selected band of radio frequencies includes the steps of frequency shifting signals by a frequency shift which varies as a function of time at a predetermined sweep rate and dispersively delaying signals over a range of time delay values as a function of frequency, and is characterised by the features claimed in the characterising portions of either claim 17 or claim 18.

A radio receiver having these features can provide the following advantages:—

1) instantaneous coherent extraction of signals of interest (SOI) located at arbitrary frequencies within a selected intercept band at or above the Nyquist rate;

2) one hundred percent time coverage of the intercept spectrum as well as redundant time coverage with window overlap;

3) a factor of

$$\frac{K(K-F_s)}{1-F_s}$$

times improvement in:

   a) increased intercept bandwidth for the same resolution and dispersive filter time-bandwidth product;

   b) increased frequency resolution for the same intercept bandwidth and dispersive filter time-bandwidth product;

   c) reduced dispersive filter time-bandwidth product for the same resolution and intercept bandwidth;

(A typical conventional microscan receiver has $K=1$, and $F_s=0.5$. Thus, the improvement factor is 28 with our invention configured with $K=4$).

4) simultaneous spectral analysis and channelization with the same receiver for reduced quipment requirements;

5) instantaneous and automatic synthesis of band pass filters at arbitrary frequencies permitting extraction of SOI, and detection of short burst and frequency agile signals.

One embodiment of the invention involves the combination of means for properly-delaying and frequency-multiplexing time segments of the intercept bandwidth coupled to a mixer in which the entire frequency multiplexed signal is swept in frequency by a swept local oscillator. These frequency swept bands are introduced into a bank of frequency-dependent delay lines whereby a plurality (K) of the chirped time segments are simultaneously filtered. These signals are then coherently summed in an adder and thereafter introduced into an in-phase and quadrature mixer/sampler combination. The sampler is activated once per sweep of the local oscillator for each desired signal of interest.

In a second embodiment, the invention involves the presence of discrete time delay means for time delaying a band of frequencies, a swept oscillator for sweeping the frequency of each discrete time delayed band of frequencies, and dispersive delay lines for dispersing the individual swept bands of frequencies as a function of their frequency. Also present are mixers for converting the frequencies as a function of related frequencies. An adder thereafter combines the outputs of the mixers.

In accordance with the method of this invention, in one embodiment incoming signals are delayed and frequency multiplexed in to a plurality of frequency bands, chirped or frequency swept, delayed in each band as a function of frequency, next coherently summed and then sampled to provide coherent channelization and improved frequency resolution.

The invention will now be described by way of example with reference to the drawings in which:

Figure 1 is a block diagram of a prior art receiver;

Figures 2 and 3 are graphical representations of the operating characteristics of the prior art receivers;

Figure 4 is a block diagram of one embodiment of this invention;

Figures 5 and 6 are graphical representations of the operating characteristics of apparatus in accordance with the invention;

Figure 7 is a block diagram of one embodiment of multiplexed compression filters employed in this invention;

Figures 8—11 are additional graphical representations of the operating characteristics of apparatus in accordance with the invention;

Figure 12 is a timing diagram for the embodiment of Figure 4;

Figure 13 is a block diagram of the timing signal source of Figure 4;

Figure 14 is a block diagram of an alternative embodiment of the invention; and

Figures 15—17 are graphical representations of the performance of apparatus in accordance with the invention as compared with prior art receivers.

As prelude to an understanding of this invention, a description and analysis of the operation of a conventional compressive receiver is believed desirable.

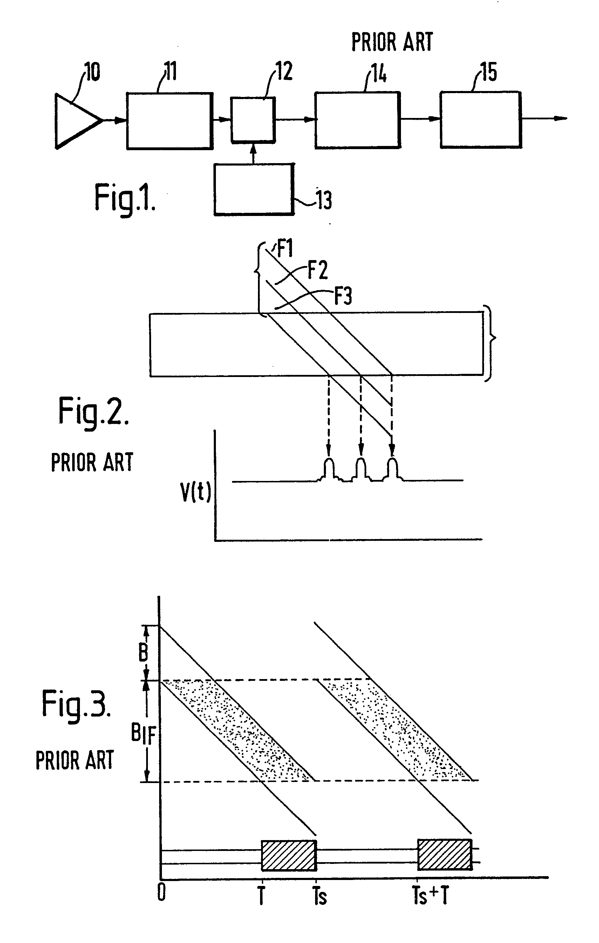

Fig. 1 shows a conventional compressive receiver in simplified block diagram form. It comprises basically a signal source represented by an antenna 10 coupled to a broadband amplifier 11 covering the frequency spectrum of interest. The amplified signal or signals from the amplifier 11 is mixed in mixer 12 with the output of a swept or chirped local oscillator 13. The converted output of the mixer 12 is introduced into a dispersive delay line or filter 14 which serves to delay in time each signal appearing at the input an amount varying with the input center frequency. Next, the delayed composite signals are envelope detected in detector 15. The graphical representation of this operation appears in Fig. 2.

Analytically, receivers of the type shown in Fig. 1, commonly called pulse compression or microscan receivers, perform a Fourier transformation of the input signal. Using complex notation to simplify the analysis, we express the output of the mixer 12 as

$$y(t)=s(t)e^{j(\omega_0 t-\pi Rt^2)}|t|\leqslant T/2 \tag{1}$$

where $s(t)$ is the signal under analysis, $\omega_0$ is the dispersive delay line 14 center frequency, and R is the swept oscillator 13 scan rate in Hz/sec. The dispersive delay line 14 is matched to the chirped signal in that its impulse response is

$$h(t)=e^{j(\omega_0 t+\pi Rt^2)}. \tag{2}$$

Thus, the filter 14 output is

$$y'(\tau)= \int_{-T/2}^{T/2} s(t)e^{j(\omega_0 t-\pi Rt^2)}e^{j(\omega_0(\tau-t)+\pi R(\tau-t)^2)}dt. \tag{3}$$

Using the window function $w(t)$ the square term, equation (3) becomes

$$y'(\tau)=e^{j(\omega_0\tau+\pi R\tau^2)} \int_{-\infty}^{\infty} w(t)s(t)e^{-j2\pi R\tau t}dt. \tag{4}$$

where $w(t)\neq 0$ for $|t|\leq T/2$ and $w(t)=0$ where $|t|>T/2$. The integral in equation (4) is the Fourier transform of $w(t)s(t)$ with R as the frequency variable. For large time-bandwidth products (TW>100) the residual FM (or chirp) term may sometimes be ignored as discussed below in the description of our Multichannel Coherent Receiver.

The resolution of the above transform is determined by the duration of the window function $w(t)$. This is because the transform of $w(t)s(t)$ is the convolution of the individual transforms, and

$$\int_{-T/2}^{T/2} w(t) \exp(-j2\pi R\tau t)dt=\frac{\sin(\pi R\tau T)}{\pi R\tau} \tag{5}$$

has an approximate bandwidth of

$$\frac{1}{T}Hz.$$

Converting equation (4) to magnitude and phase notation gives

$$\exp(j\omega_0\tau+j\pi R\tau^2) \int_{-\infty}^{\infty} w(t)s(t) \exp(-j2\pi R\tau) dt \triangleq A(2\pi R\tau) \exp(j\phi(2\pi R\tau)+j\omega_0\tau+j\pi R\tau^2). \tag{6}$$

The output of the envelope detector 15 in Fig. 1 is then $A(2\pi R\tau)$, the magnitude of the desired Fourier transform.

The above process is repeated for each sweep of the local oscillator 13 and the result is a transform every $T_s$ seconds.

POI Considerations

An expanded frequency versus time plot for the conventional compressive receiver shown in Fig. 1 is presented in Fig. 3. The input bandwidth is indicated by B, and the dispersive matched filter 14 bandwidth by $B_{IF}$. The grey area in each sweep is the region in time and frequency during which the chirped input is visible to the matched filter 14.

Although the IF bandwidth at the output of mixer 12 may in general be greater than or less than that indicated in Fig. 3, the IF as shown results in the maximum resolution for a given scan time

4

(consistent with uniform resolution across the input band and maximum receiver sensitivity) possible for conventional receivers.

As indicated by the NO INTERCEPT region at the bottom of Fig. 3, signals occupying the lower frequencies in the input bandwidth fall out of the IF window after T seconds. Similar regions exist for all signals within the input band, as may be seen from Fig. 3.

Ignoring signal to noise ratio considerations, POI is usually defined as the fraction of sweep time, $T_s$ that a signal is visible to the compressive filter 14. Thus,

$$POI = \frac{T}{T_s}. \tag{7}$$

Typically,

$$T = \frac{1}{2} T_s$$

and POI=0.5. Only in the limit, as the input bandwidth approaches 0 Hz, or the scan rate R becomes infinite, does the conventional compressive receiver as defined above achieve 100 percent POI.

The POI problem is also directly related to the resolution-revisit time difficulty. In order to sweep the entire input bandwidth through the IF window, the receiver must ensure $T_s < T + B/R$. This conflicts with a revisit time $T_s < T$ commensurate with the resolution (or channelization filter bandwidth)

$$\frac{1}{T} Hz.$$

The time B/R sec. is the minimum required overhead. Thus, the conventional receiver is too slow relative to the Nyquist rate by B/R seconds.

Our multichannel coherent receiver

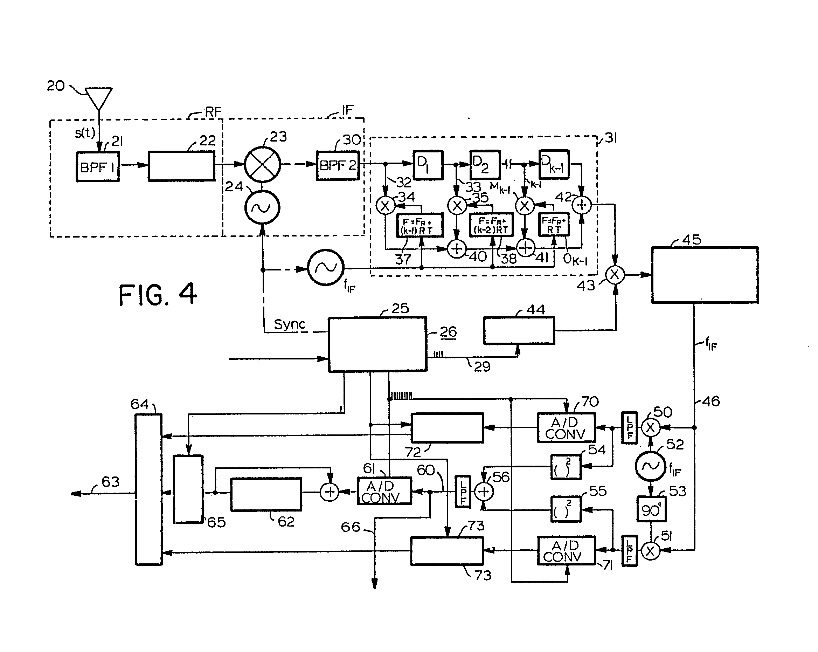

The problems of sampling rate and POI of the conventional receivers are solved employing our receiver design which is capable of both channelization and improved frequency resolution. Our basic circuit design appears in Fig. 4. It employs a signal source represented as antenna 20 which feeds a first band pass filter 21 either directly or through an RF amplifier, not shown, and a gain control circuit 22 to a mixer 23 where mixer 23 combines the incoming broad band signal from antenna 20 with a local oscillator frequency $F_1$ from an oscillator or frequency synthesizer 24, which may be free running or synchronized by a master clock 25 which is a part of a timing and control circuit generally designated 26. This possible synchronization input is indicated by a dash-dot line.

The output of the mixer 23 is an intermediate frequency band containing a replica of the input band from band pass filter 21 I.F. converted. After filtering in second band pass filter to eliminate all but the IF band, the converted signal is introduced into a series of delay lines or a single tapped delay line 31 having K—1 sections $D_1$- - - - $D_{K-1}$, each of T seconds delay and K—1 taps designated as 32, 33 - - - - K—1, where K equals the number of multiplexed time windows desired. The frequency multiplexed delay circuit 31 also includes a number of oscillators 37, 38 - - - - $O_{K-1}$ separated in frequency by (RT)hz generating frequencies $F = F_R + (K-1)RT$ - - - - $(K-1)RT$ along with their associated mixers 34, 35 - - - - $M_{K-1}$ to up convert the respective delayed IF signals by RT Hz as RT is later defined.

The frequencies $F = F_R + (K-1)RT$ - - - - $F = F_R + RT$ generated by local oscillators 37, 38 - - - - $O_{K-1}$ may each be generated simply by mixing the output frequency of additional local oscillators $(K-1)RT$ - - - - RT with the reference frequency $F_R$.

The up converted delayed signals are each summed with the succeeding signal in respective summers 40 and 41 while the output of the delay stage $D_{K-1}$ without up conversion is summed with the output of summer 41 in summer 42. The output of summer 42 is in turn mixed in mixer 43 with the output of a variable frequency or swept local oscillator 44. The nature of the signal output of mixer 43 is best described below in the section, Multiplexed Time Delay Subsystem.

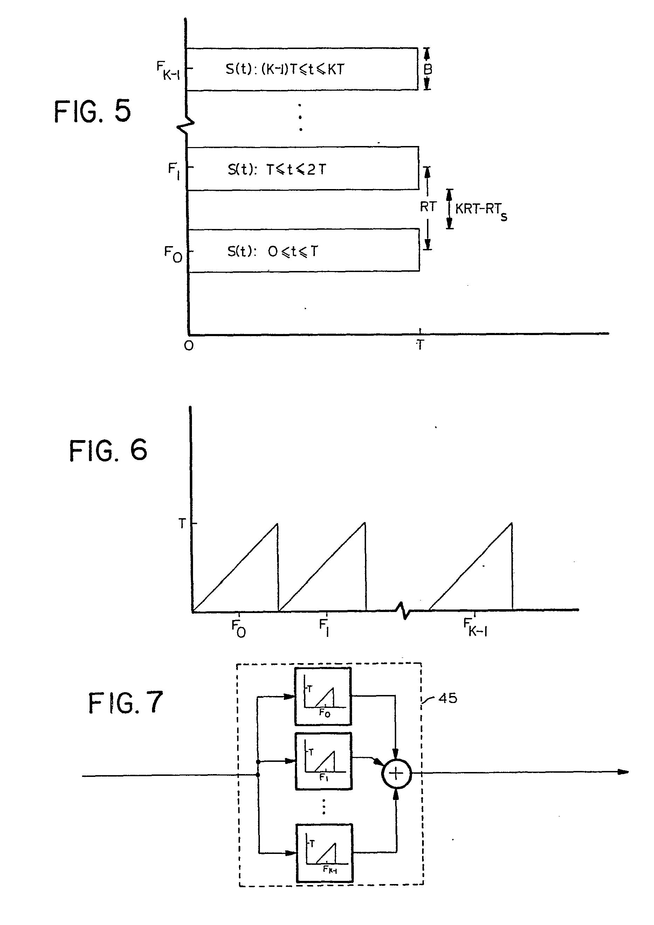

Suffice it to say, the frequency multiplexed and delayed signal is introduced into a matched multiplexed compression filter 45 having a characteristic as shown in Fig. 6 and having one embodiment illustrated in Fig. 7. This matched compression filter produces at its output, as described below, the Fourier transform of the receiver input signal band having a true time window of KT second duration. This output on lead 46 is fed into a conventional in phase and quadrature sampler including mixers 50 and 51, local oscillator 52 and 90 phase shifter 53. The output of the in phase and quadrature mixers is detected in a pair of square law detectors 54 and 55, the former associated with the in-phase or I component and the latter with the quadrature or Q component. The detected I and Q components may then be combined in adder 56 whereupon the amplitude spectrum of the signal band is produced on output lead 60 of adder 56. The signal may then be digitized if desired in A/D converter 61, integrated by the shift register 62 and summer 67 and produces an output on lead 63 via a multiplexer 64 under the control of a readout control switch 65. The reconstructed analog signal may also be extracted prior to digital conversion via lead 66.

Alternate utilization of the I and Q components is accomplished while retaining the phase information by converting the output of I mixer 50 to digital form in A/D converter 70 and simultaneously converting the Q output of mixer 51 to similar form in A/D converter 71. The digitized I and Q components of any of the signals of interest within the signal band may then be introduced into respective channels of multiplexer 64 under the control of emitter selector switches 72 and 73 respectively, operated by the timing control circuit 26.

Emitter selector 72 is merely a frequency selector used when the input signal of antenna 20 contains a number of signals originating at different frequencies. Emitter-selectors 72, 73 extract I and Q samples at times within each sweep corresponding to the center frequency at each desired emitter.

In Fig. 4, the A/D converter 70, 71 is shown operating at clock rate and the emitter selectors 72, 73 are operated at a variable rate depending upon the control input from the Timing & Control circuit 26 which may be any rate up to the clock rate. In general a few particular emitters will be the object of interest and the rate of pulses to emitter selectors 72 and 73 will correspond in number and in time location for each sweep related to the frequency of the emitters of interest.

An alternate approach is to just operate or trigger the A/D converters 70 and 71 at times corresponding to the wanted emitter locations. In such case the A/D converters 70 and 71 and emitter selectors 72 and 73 may be operated by a common control input.

Employing this invention a plurality of signals are frequency multiplexed and accumulated in a time delay subsystem presenting a signal time window T as shown in Fig. 5. This figure illustrates that K segments of the input signal may be multiplexed so that KT seconds of signal may be accumulated in one T second period. Search for signals of interest in the band and channelization of signals for analysis, reproduction or retransmission may easily be accomplished by the single receiver in accordance with this invention while meeting the Nyquist sampling criteria.

The multiplexed time delay subsystem

Central to the unaliased channelization of signals located within the receiver bandwidth is the relationship between scan time $T_s$ (sampling period) and filter bandwidth $\Delta f$ (resolution). Specifically,

$$T_s < \frac{1}{\Delta f}$$

for Nyquist or better sampling.

Our Multichannel Coherent receiver creates an effective receiver time window for which

$$T_s < \frac{1}{\Delta f}$$

through frequency multiplexed time delay circuit 31 as shown in Fig. 4. The input signal is routed to the delay line 31 and to a mixer 42 for up-conversion by RT Hz (R=chirp oscillator scan rate in Hz/sec,

$$T = \frac{1}{k\Delta f}.$$

The delay line has (k—1) taps, the signal out of each tap delayed by T sec relative to the previous tap.

The total signal input to the chirp oscillator mixer 43 is the sum of the (k—1)T sec delayed input, the (k—2)T sec delayed input translated by RT Hz, and (k—3)T sec delayed input translated by 2RT Hz, and so on. This may be written as

$$s_0(t) = s(t-(k-1)T)\sin(\omega_{IF}t) + s(t-(k-2)T)\sin(\omega_{IF}+2\pi RT)t + \ldots + s(t)\sin(\omega_{IF}+(k-1)RT)t$$

$$= \sum_{n=1}^{k} s(t-(k-n)T)\sin(\omega_{IF}+(n-1)2\pi RT)t \qquad (8)$$

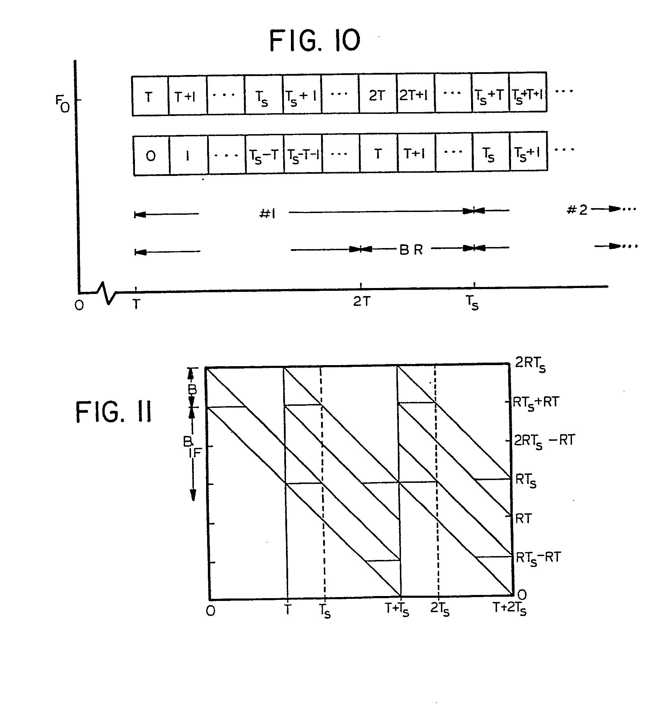

where s(t) is the input signal. If we observe the output for a period of T sec (after waiting at least (k—1)T sec for initiation) we see the situation shown in Fig. 10 (for k=2).

The output signal is a frequency multiplexed signal with the unique property that any T sec segment contains kT sec of the input signal (at a cost of increased bandwidth).

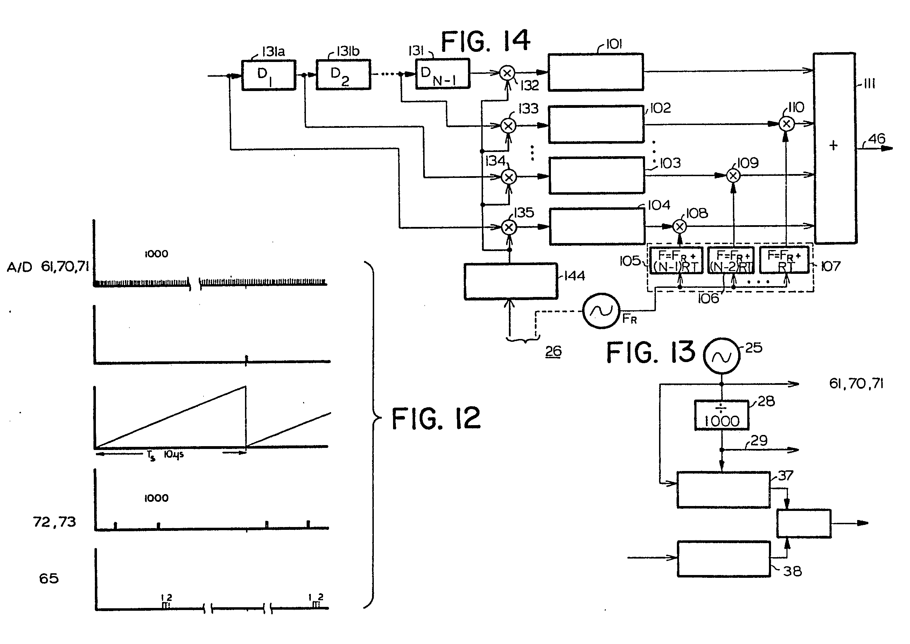

When input to the swept oscillator, the frequency versus time diagram shown in Fig. 11 is appropriate (for the $k=2$ case). note that during each sweep time $T_s$ we have an effective 2T sec window. Thus, the eventual resolution is

$$\frac{1}{2T}\text{Hz.}$$

The required sampling period for such a filter is $T_s<2T$. (The general Nyquist requirement is $T_s<kT$). As long as

$$T>\frac{s}{k}$$

the Multichannel Coherent Receiver is able to achieve Nyquist (or faster) sampling.

Above we described the conventional compressive receiver and indicated that $T_s>T$. Here we point out that the conventional receiver may be interpreted as a special case of multichannel coherent receiver with $k=1$. However, for Nyquist sampling a necessary condition is $k\geq2$.

The output of the swept oscillator 44 of Fig. 1 as shown in Fig. 11 is compressed by the second Multichannel Coherent receiver subsystem, the multiplexed compression filter 45.

Multiplexed compression filter

In, order to form the Fourier transform of the input signal s(t), the swept output of the chirp oscillator mixer 43 must be processed by the appropriate matched filter. Such a filter is shown in Fig. 7. Perhaps the most straightforward means of realizing this filter is the use of k separate dispersive delay lines, each at an appropriate center frequency as shown in Fig. 7. Another approach is to fabricate a single filter having the characteristics shown in Fig. 6. The broad utilization of the Multichannel Coherent receiver of this invention will undoubtedly call for the development of a single filter having the required characteristics.

We next derive the output of the matched filter 45. With reference to equation 8, let the output of the chirp oscillator 44 be

$$c(t)=\left(\sum_{n=1}^{k} s(t-(k-n)T)e^{-j2\pi(n-1)RT(t-(k-1)T)}\right)e^{-j\pi R(t-(k-1)T)^2} \qquad (9)$$

where we have used complex notation for convenience, and perform the analysis of baseband to further simplify the equations.

Recall that the frequency multiplexed delay line begins yielding valid output after an initial delay of $(k-1)T$ sec;

$$c(t+(k-1)T)=\left(\sum_{n=1}^{k} s(t+(n-1)T)e^{-j2\pi(n-1)RT(t+(k-1)T)}\right)e^{-j\pi Rt^2}. \qquad (10)$$

The impulse response of the frequency multiplexed matched filter is given by

$$h(t)=e^{-j2\pi(n-1)RT(t)}e^{+j\pi Rt^2}\, n=1,2\ldots,k \qquad (11)$$

So the output of the multiplexed filter 45 is

$$y(\tau)=\int_o^T \sum_{n=1}^{k} s(t+(n-1)T)e^{-j2\pi(n-1)RTt}e^{-j\pi Rt^2}e^{j\pi R(\tau-t)^2}e^{-j2\pi(n-1)RT(\tau-t)}dt$$

$$=e^{j\pi R\pi^2} \sum_{n=1}^{k} e^{-j2\pi(n-1)RT\tau} \int_o^T s(t+(n-1)T)e^{-j2\pi R\pi t}dt. \qquad (12)$$

Changing variables within the integral gives

$$y(\tau)=e^{j\pi R\tau^2} \sum_{n=1}^{k} e^{-j2\pi(n-1)RT\tau} \int_{(n-1)T}^{nT} s(\alpha)e^{-j2\pi R\tau(\alpha-(n-1)T)}d\alpha \qquad (13)$$

$$=e^{j\pi R\tau^2} \sum_{n=1}^{k} \int_{(n-1)T}^{nT} s(\alpha)e^{-j2\pi R\tau\alpha}d\alpha$$

$$= \boxed{e^{j\pi R\tau^2} \int_{0}^{kT} s(\alpha)e^{-j2\pi R\tau\alpha}d\alpha}$$

Equation 13 is a key result. It states that a T sec segment of the chirped output of the frequency multiplexed time delay circuit 31, when passed through the filter 45 shown in Fig. 7, is the Fourier transform of s(t) having a true time window of kT sec duration. Thus the resolution (or filter 4y bandwidth) is approximately

$$\frac{1}{kT}\text{Hz.}$$

The left term in equation 13 is an undesired residual FM (or chirp) modulating the desired transform. This may be removed in a straightforward manner by de-chirping the matched filter 45 output. However, this may not be necessary if we restrict the Multichannel Coherent receiver to extraction of signals of interest having bandwidth on the order of or less than the channelization filter 45 bandwidth

$$\frac{1}{KT}\text{Hz.}$$

Let s(t) be a signal of interest with bandwidth

$$\frac{1}{kT}\text{Hz.}$$

The Multichannel Coherent receiver output of interest for this signal will last $\Delta\tau$ sec, where

$$\Delta\tau=\frac{1}{RkT}, \qquad (14)$$

for $\Delta\tau$ sec the residual FM frequency will will be changed to $\Delta f$ Hz, where

$$\Delta f=R\Delta\tau$$

$$=\frac{1}{kT}. \qquad (15)$$

If the period of this maximum frequency is significantly larger than the duration of the desired output, then we may ignore the term. This condition is

$$\frac{1}{\Delta f}>>\Delta\tau, \qquad (16)$$

or

$$(kRT)(kT)>>1. \qquad (17)$$

However, the above product is the equivalent time-bandwidth product (TW) of the frequency multiplexed matched filter 45. Thus, for large TW(>100) we may be able to ignore the residual FM term. We point out the gain $(k^2)$ in TW achieved by the filter 45. This means that the individual TW products (if we use the k-parallel filter approach) may be relaxed by a factor of $k^2$ to achieve a given effective TW.

8

Channelization

Each of the previous sections has discussed a particular subsystem of the receiver for the overall purpose of establishing the kT sec window and resulting k-times improvement in frequency resolution, and perhaps most importantly the attendant capability of Multichannel Coherent receiver to achieve Nyquist and greater sampling of

$$\frac{1}{kT}$$

filters when $kT > T_s$.

Expanding upon the previous result, we may derive the Multichannel Coherent receiver output for a general bandpass intercept and arbitrary matched filter 45 center frequency. Using strictly real signals one may see how the I+Q mixer generates the real and imaginary parts of the input signal Fourier transform translated to baseband.

First, we use standard I+Q representation of an arbitrary bandpass signal s(t).

$$s(t)=s_p(t) \cos (\omega_c t)+s_q(t) \sin \omega_c t \tag{18}$$

$$=e(t) \cos (\omega_c t-\phi(t)),$$

where

$$e(t)=2\sqrt{s_p^2(t)+s_q^2(t)}, \tag{19}$$

and

$$\phi(t)=\tan^{-1}\frac{s_q(t)}{s_p(t)},$$

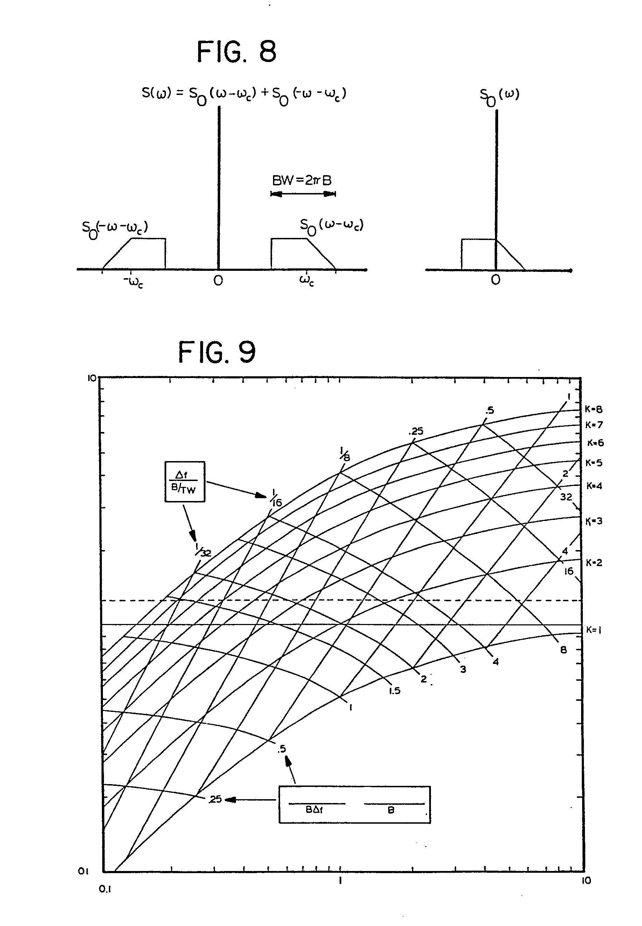

as shown in Fig. 8.

We also show the spectrum of the baseband complex functions $s_0(t)$, where

$$s_0(t)\underset{\cdot}{\underline{\underline{\Delta}}}LPF\{s(t)e^{-j\omega_c t}\} \tag{20}$$

$$=e(t)e^{j\phi(t)},$$

where LPF {.} indicates passage through a low pass filter having two sided bandwidth B. The signal defined in equation 20 is now shown to be the in-phase and quadrature output of the Multichannel Coherent receiver I+Q mixer 56.

Using equation 18, the output of the chirp oscillator mixer 43 is: (21)

$$c(t)=e(t) \cos (\omega_c t-\phi(t)) \cos (\omega_1 t-\pi Rt^2)$$

$$=\tfrac{1}{2}(t) \cos (\omega_{IF}t-\phi(t)+Rt^2),$$

where we eliminate the sum frequency term, and $\omega_{IF}=\omega_c-\omega_1$.

The output of the matched filter 45 is then (dropping the multiplicative constants),

$$y(R\tau)= \int_o^T c(t) \cos (-\omega_{IF}(\tau-t)+\pi R(\tau-t)^2)dt, \tag{22}$$

which becomes

$$y(R\tau)=-\cos (\omega_{IF}\tau-\pi R\tau^2) \int_o^T e(t) \sin (\phi(t)-2\pi R\tau t)dt \tag{23}$$

$$+\sin, (\omega_{IF}\tau-\pi R\tau^2) \int_o^T e(t) \cos (\phi(t)-2\pi R\tau t)dt.$$

We next pass the above signal through the in-phase (cos $(\omega_{IF}\tau)$) and quadrature (sin $(\omega_{IF}\tau)$) mixers 50 and 51 to get

$$\text{I-channel:} - \int_0^T e(t) \sin (\phi(t) - 2\pi R\tau t) dt \qquad (24)$$

$$\text{Q-channel:} \int_0^T e(t) \cdot \cos (\phi(t) - 2\pi R\tau t) dt$$

where, as discussed above, we have eliminated or ignored the residual FM. The I-channel output may be written,

$$\text{I-channel: Imag} \left\{ \int_0^T e(t) e^{j\phi(t)} e^{-j2\pi R\tau t} dt \right\} \qquad (25)$$

and the Q-channel

$$\text{Q-channel: Real} \left\{ \int_0^T e(t) e^{j\phi(t)} e^{-j2\pi R\tau t} dt \right\}. \qquad (26)$$

Referring back to equation 20, we see that the I+Q mixers 50 and 51 outputs are the imaginary and real parts of the Fourier transform of the baseband signal $s_0(t)$. When this transform is sampled, once per scan, the resulting multiplexed compression receiver output is exactly the same as if a bandpass filter had been placed at $\omega_c$, and the output translated to basebad. This is the channelization property of the Multichannel Coherent receiver.

Alternate embodiment
In the situation where the Multichannel Coherent Receiver of this invention is desired but the intermediate frequency bandwidth is limited or when $K/F_s < 2$, the modified receiver of Fig. 14 is to be used. This embodiment replaces the circuitry of Fig. 4 between the output of bandpass filter 30 (BPF2) and lead 46, the output of the multiplexed compression filter 45.
Employing this alternate configuration the composite input signal from band pass filter 30 is introduced into a tapped delay 131 having a number of sections 131A - - - - 131N. The time delay between taps is T seconds. The individually delayed signals at the taps are each multiplied with a common swept local oscillator frequency from oscillator 144 in respective mixers 132—135, then introduced into identical (matched) respective dispersive filters 101—104. These outputs are then up converted in frequency by mixing in respective mixers 108, 109, 116 with the output of synchronized local oscillators 105—107 having frequencies related f=(k—1)RT, f=(k—2)RT and f=RT just as in the frequency multiplexed delay circuit 31 of Fig. 4. The signals are next summed in adder 111 ready for introduction into the in-phase and quadrature samplers of Fig. 4.
The advantages of the embodiment of Fig. 14 in the IF bandwidth limited situation are apparent. Employing the embodiment of Fig. 4, the entire IF band is carried in one signal channel, e.g. the lead between the bandpass filter 30 and the frequency multiplexed delay. This may exceed the capabilities of the existing components capabilities in bandwidth. Likewise, each band as illustrated in Fig. 5 must be separated by a dead band so the bandwidth B is limited.
Employing the alternate embodiment of Fig. 14, each delayed segment is carried on a separate lead, through a separate mixer 132—135 and thus are isolated from each other until recombined in adder 111. The individual bands are smaller in bandwidth than the single band of Fig. 4 and the individual bands may overlap.
Fig. 14 shows only N—1 mixers 108—110 when operating at the IF frequency, - - - the simplest case from the equipment standpoint. All output lines from the dispersive filters 101—104 will have a respective mixer if it is desired to produce the output at a different IF.

Timing and control
Timing is accomplished employing the master clock and timing control circuit 26 of Fig. 4. A typical circuit 26 is illustrated in Fig. 13 and its output waveforms illustrated in Fig. 12.
Referring now to Fig. 13, the timing and clock circuit comprises basically a master clock, oscillator 25 which provides the basic clock rate for the system. Its clock rate is chosen arbitrarily. Master clock 25 provides clock frequency on lead 27 to the Analog to Digital converters 61, 70 and 71. The basic clock frequency $F_0$ is divided in divide by 1000 divider circuit 28 to produce a trigger pulse on lead 29 to trigger each sweep of oscillator 44.
The timing and control circuit also includes a counter 37, digital memory 38 and comparator 39. Pulses from the master clock 25 are introduced into the counter 37 and the counter is reset each time the local oscillator 44 is triggered. Thus the frequency position of a signal is related to the count in the

10

counter 37. The external command applied to the digital memory 38 establishes a count which is the equivalent of the frequency or emitter desired to be processed. This count is introduced into a comparator 39 so that each time coincidence exists in counter 38, comparator 39 provides enabling pulses to the emitter selectors 72, 73, which merely are switches to allow the passage of signals when they are enabled.

Multichannel coherent receiver spectrum analysis

When used as an improved resolution spectrum analyzer, the Multichannel Coherent receiver output given in equation 23 is simply envelope detected as illustrated in Fig. 4. Thus, we square and add the I+Q mixer outputs given in equation 24 to obtain.

$$I^2(R\tau)+Q^2(R\tau)=A^2(R\tau)\sin^2(\psi(R\tau))+A^2(R\tau)\cos^2(\psi(R\tau)) \tag{27}$$

$$=A^2(R\tau)$$

which is the magnitude of the desired spectrum, where

$$A(R\tau)e^{j\psi(R\tau)}\underset{=}{\Delta}\int_0^T e(t)e^{j\phi(t)}e^{-j2\pi R\tau t}dt. \tag{28}$$

Multichannel coherent receiver parameter relationships

When employing the Multichannel Coherent receiver, there are a number of parameters that must be chosen to specify a given Multichannel Coherent receiver performance. We list below the parameters most frequently encountered.

Independent multichannel coherent receiver parameters

| Receiver parameter | Definition |
|---|---|
| B | Intercept Bandwidth (Hz) |
| $\Delta F$ | Frequency resolution or channelization filter bandwidth (Hz) |
| k | Number of multiplexed time windows; improvement in frequency resolution over conventional receivers; number of taps on delay line. |
| $F_s$ | MCR sampling rate relative to Nyquist ($F_s \geq 1$ for channelization). |

Once the above parameters are independently specified, the following parameters are determined.

# 0 032 276

Dependent multichannel coherent receiver parameters

| Parameter | Value | Definition |
|---|---|---|
| T | $\dfrac{1}{k\Delta f}$ | Time delay between delay line taps (sec). |
| $T_s$ | $\dfrac{1}{F_s\Delta f}$ | MCR scan time (sec). |
| TW | $\dfrac{B}{k\Delta f\left(\dfrac{k}{F_s}-1\right)}$ | Time-bandwidth product of each multiplexed dispersive delay line |
| R | $\dfrac{Bk\Delta f}{\left(\dfrac{k}{F_s}-1\right)}$ | MCR scan rate (Hz/sec.) |
| $B_{IF}$ | $\dfrac{B}{\left(\dfrac{k}{F_s}-1\right)}$ | Bandwidth of each multiplexed dispersive delay line (Hz). |
| $B_{OUT}$ | $\dfrac{kB}{\left(\dfrac{k}{F_s}-1\right)}$ | MCR output bandwidth in the spectrum analyzer mode (Hz). |

Obviously the above partition into independent and dependent variables is arbitrary, but we have found that a typical design sequence begins with at least a rough knowledge of the desired intercept bandwidth and resolution, and that the sampling rate should be at least 1.25 to 2 times Nyquist ($1.25 < F_s < 2.0$).

Fig. 9 shows the functional relationships between all of the above parameters, and how one may be traded against another. As an example of the utility of the chart suppose that the following multichannel coherent receiver characteristics are desired.

Typical example multichannel coherent receiver parameters

| Parameter | Value |
|---|---|
| B | 30 Mhz |
| $\Delta F$ | 10 KHz |
| $F_s$ | 2 |
| k | 4 |

Referring to Fig. 9, the intersection of the $F_s=2$ and $k=4$ curves is the resulting Multichannel Coherent receiver operating point. Moving vertically down to the abscissa, one can see that the required bandwidth per multiplexed dispersive delay line is $1 \times 30$ MHz=30 MHz. The negatively sloped curve through the operating point indicates that the output bandwidth for the spectrum analyzer mode is $4 \times 30$ MHz=120 MHz, and that the required scan rate is $30 \times 10^6 \times 10^4 \times 4 = 1.2$ MHz/$\mu$sec. The positively sloped curve through the operating point states that the required time-bandwidth product for each of the four multiplexed dispersive delay lines if

12

$$\frac{30 \times 10^6}{10^4} \left(\frac{1}{4}\right) = 750.$$

Now say the output bandwidth of 120 MHz in the multiplexed compression receiver spectrum analyzer mode is considered too large, but the intercept bandwidth, frequency resolution, and time-bandwidth product must remain the same. One may then stay on the

$$\frac{\Delta f}{B/TW} = \frac{1}{4}$$

curve and move to the lower left to reduce the output bandwidth (at a cost of reduced sampling rate, in this example).

It is also pointed out that the k=1 curve is the locus of operating points for conventional compressive receivers, as defined above. Note that the curve only asymptotically approaches $F_s = 1$ (or Nyquist sampling), as the IF bandwidth increased to infinity, or the intercept bandwidth decreases to zero.

Although specifically designed to achieve coherent channelization of signals of interest, the Multichannel Coherent Receiver of this invention also provides significant advantages when applied to spectrum analysis and/or signal search.

In this section we characterize the Multichannel Coherent receiver as an instantaneous frequency measurement (IFM) receiver, and compare its performance to the conventional receiver described above.

All of the receiver parameters defined above are, of course, still appropriate, but here we focus on the $F_s \leq 1$ region. In addition, we define the following generic design parameters for IFM receivers.

MCR/IFM Receiver parameters

| Parameter | Definition | Value | Comment |
|---|---|---|---|
| Relative Compression Factor | $\dfrac{B/\Delta f}{TW}$ | $\dfrac{k}{k\left(\dfrac{k}{F_s} - 1\right)}$ | Numerator is number of frequency resolution cells, denomenator is dispersive filter time-bandwidth product. Measure of efficient use of TW. |
| Relative Output Bandwidth | $\dfrac{B_o}{B}$ | $\dfrac{k}{\dfrac{k}{F_s} - 1}$ | Ratio of receiver output-to-input bandwidth. |
| MCR Compression Gain | $\dfrac{\dfrac{B/\Delta f}{TW} \ (MCR)}{\dfrac{B/\Delta f}{TW} \ (conventional)}$ | $\dfrac{k(k - F_s)}{1 - F_s}$ | Measure of increased MCR resolution for same TW, or reduced TW for same resolution. |
| Probability of Intercept (Receiver duty cycle) | $F_s$ | $0 < F_s < 1$ | Sample as defined above but emphasis on $F_s < 1$. |

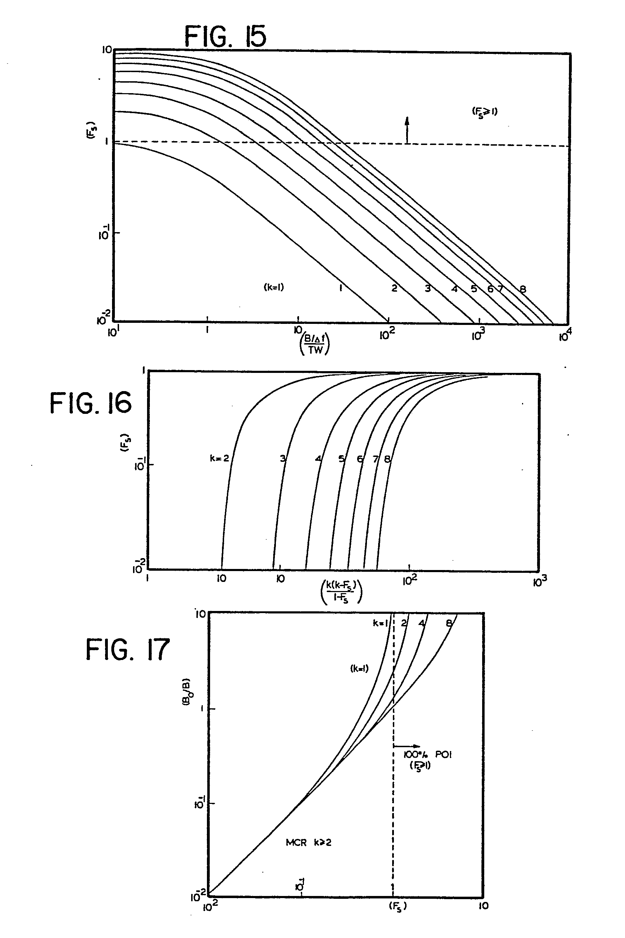

Fig. 15 shows the relationship between relative compression factor and receiver duty cycle (POI). The curves point out the trade required between POI and compression factor — higher POI always demand more time bandwidth product (TM) for the dispersive filter 31, reduced resolution, or both. The Multichannel Coherent receiver configured with four (k=4) multiplexed time delays improves the situation by achieving higher POI for a given compression factor, or higher resolution (or lower TW) for a given POI. For example, the Multichannel Coherent receiver with k=4 realizes a factor of 30 increase in resolution for the same time bandwidth product (TW) and POI (50%) when compared to the conventional receiver. This relative improvement is shown parametrically in Fig. 16 as a function of

13

# O 032 276

receiver duty cycle. The compression gain may be interpreted as the increase in resolution (or reduction in TW) for Multichannel Coherent receiver relative to conventional (IFM) Instantaneous Frequency Measurement receivers. At low duty cycles, the Multichannel Coherent receiver compression gain approaches its minimum of $k^2$. For higher values of $F_s$ the gain becomes quite large, being approximately 30 for k=4 and $F_s$=.5.

Output bandwidth is an important consideration in the selection of Instantaneous Frequency Measurement parameters, and often prevents the realization of desired POI and/or resolution. In Fig. 17 we show the relationship between POI and relative output bandwidth ($B_0/B$). Note that the Multichannel Coherent Receiver achieves essentially the same output bandwidth as conventional receivers for low POI, and actually reduces the output bandwidth at high (>0.1) POI. When viewed in light of the previous two figures, this means significantly improved resolution with no increase in output bandwidth (for POI=50% and k=4 the bandwidth is reduced by more than a factor of 2, while the resolution is increased by a factor of 30 for the same Time Bandwidth Product).

The three curves, Figs. 15—17, should allow the reader to perform comparative traces between Multichannel Coherent Receiver and conventional Instantaneous Frequency Measurement receivers, regardless of the particular bandwidth, resolution, etc. required by each application.

The Multichannel Coherent Receiver has been shown to achieve significant improvement in resolution, POI, and required Time Bandwidth Product (TW). At the same time, the Multichannel Coherent Receiver is capable of operating as a coherent channelization receiver. This combination of efficient signal search and coherent extraction of Signal of Interest (SOI) can provide an attractive receiver for the signal collection problem.

## Claims

1. Signal processing apparatus for analysing a band of input signals as, for example, from radio receiver circuitry, the apparatus comprising frequency shifting means (43, 44) providing a frequency shift which varies as a function of time, said frequency shifting means comprising a variable frequency oscillation generator (44) having a predetermined sweep rate which is connected to an input of a first mixing means (43), and dispersive delay means (45) for delaying signals over a range of time delay values as a function of frequency, the apparatus being characterised by: a delay line (31) including a plurality of taps ($D_1 \ldots D_{k-1}$) and having an input for receiving the band of input signals; frequency generating means (37, 38 . . . ) having a respective output for each of the taps, each output supplying a signal having a frequency which is a function of (k—n)RT where k—1 is the number of taps, R is the sweep rate of the oscillation generator (44), T is a constant, and n is the number of a particular tap; second mixing means (34, 35 . . . ) for mixing the output of each tap with its respective output of the frequency generating means (37, 38 . . . ) to provide a plurality of frequency shifted discrete representations of the band of input signals; means (42) for combining the frequency shifted representations to produce frequency multiplexed and delayed representations; the first mixing means (43) mixing the output of the variable frequency oscillation generator (44) with the output of the combining means; dispersive filter means (45) coupled to the output of the mixing means (43), having a delay-frequency characteristic matched to the time variation rate of the variable frequency oscillation generator, with a maximum delay value T; and output circuitry (50—73) coupled to the output (46) of the filter means (45), whereby the apparatus develops a Fourier transformation of the input signals with amplitude and phase information preserved and a 100% probability of intercept.

2. Signal processing apparatus for analysing a band of input signals as, for example, from radio receiver circuitry, the apparatus comprising frequency shifting means (132—135, 144) providing a frequency shift which varies as a function of time, said frequency shifting means comprising a variable frequency oscillation generator (144) having a predetermined scan rate which is connected to an input of a first mixing means (132—135), and dispersive delay means (101—104) for delaying signals over a range of time delay values as a function of frequency, said signal processing apparatus being characterised by: a tapped delay line (131a, 131b . . . ) having an input for receiving the band of input signals; said first mixing means (132—135) mixing the signals at taps of the delay line with an output signal of the oscillation generator (144) to produce a plurality of variably delayed representations of the signals, said dispersive delay means comprising a plurality of dispersive delay lines (101—104) each respectively coupled to outputs of the first mixing means (132—135) and each having a frequency-delay characteristic matched to the frequency variation characteristics of the oscillation generator (144); frequency generating means (105, 106, 107) having a plurality of outputs, each output supplying a respective output signal of a respective frequency F=(k—n)RT, where k—1 is the number of taps of the tapped delay line (131a, 131b . . . ), n is the number of a particular tap, R is the scan rate of the oscillation generator (144) and T is the maximum delay of the dispersive delay lines (101—104); a plurality of second mixing means (108, 109, 110) for respectively combining the outputs signals of the frequency generating means (105, 106, 107) with the output signals of the delay lines (101—104) corresponding to respective taps of the tapped delay line (131a, 131b . . . ); and means (111) for combining the outputs of the mixers (108, 109, 110).

14

3. A radio receiver comprising the combination of signal processing apparatus according to claim 1 or claim 2, and input circuit (20—22) for receiving a radio signal, a local oscillator (24) and means (23) for mixing a radio signal received in the input circuit with at least one local oscillator frequency to produce an intermediate frequency product for feeding to the signal processing apparatus.

4. Signal processing apparatus according to claim 1, characterised in that the filter means (45) has a plurality of linear time frequency sections.

5. Apparatus according to claim 4, characterised in that each of the frequencies of the sections is central about the centre frequency of the product from the combining means.

6. Apparatus according to claim 1, claim 4 or claim 5, characterised by first and second means (50, 51) coupled to the output of the filter means (45) for deriving quadrature components of the signal output of the filter means.

7. Apparatus according to claim 6, characterised by means (54, 55) for detecting the outputs of the first and second quadrature component deriving means (50, 51); and means (56) for adding the output of the detecting means to produce a reconstruction of analogue signals received.

8. Apparatus according to any of claims 1 and 4 to 7, characterised in that the combining means (42, 111) is an adder.

9. Apparatus according to any of claims 1 and 4 to 8, characterised in that the variable frequency oscillation generator (44, 144) is a linear sweep local oscillator.

10. Apparatus according to any of claims 1 and 4 to 9, characterised by means (26) for triggering said variable frequency oscillation generator (44, 144) once for each of a plurality of sweep periods.

11. Apparatus according to claim 6, characterised in that the output circuitry comprises:

first and second analogue to digital converters (70, 71) coupled to the outputs of respective quadrature component deriving means (50, 51);

switch means (72, 73) coupled to the outputs of the analogue to digital converters (70, 71); and

timing means (25) coupled to the variable frequency oscillation generator (44) to trigger its frequency variation and coupled to the switch means (72, 73) to switch said switch means to a conducting condition at a time related to a selected frequency of the variable frequency oscillation generator (44).

12. Apparatus according to claim 11 characterised in that the variable frequency oscillation generator (44) is a linearly sweeping oscillator and the timing means (25) enables the switch means (72, 73) at a time after commencement of sweeping of said linearly sweeping oscillator related to the required frequency to be processed.

13. Apparatus according to claim 11 or claim 12, characterised by individual switch means (72, 73) for each of said quadrature component deriving means (50, 51).

14. Apparatus according to claim 6, claim 11, claim 12 or claim 13, characterised by a pair of square law detectors (54, 55) coupled to respective quadrature component deriving means (50, 51) for detecting two orthogonal components of signals; and means (56) for adding said detected components to reconstruct a time amplitude spectrum of the signal band at the input of the apparatus.

15. Apparatus according to claim 6, characterised in that the output circuitry comprises a pair of signal detectors (54, 55) respectively coupled to the quadrature component deriving means (50, 51), and means (56) for combining the output of the detectors.

16. Apparatus according to claim 15, characterised in that the combining means (56) is an adder.

17. A method of processing signals received in a selected band of radio frequencies including the steps of frequency shifting signals by a frequency shift which varies as a function of time at a predetermined sweep rate and dispersively delaying signals over a range of time delay values as a function of frequency, characterised in that an incoming frequency band of signals is delayed by discrete amounts, in that the said frequency shifting step is performed on each of the resulting delayed representations as a function of time, and in that the delayed and frequency shifted representations are combined and subjected to the dispersive delaying step in accordance with a delay-frequency characteristic which is matched to the variation of the said frequency shift to produce an output which is a Fourier transformation of the incoming band of signals.

18. A method of processing signals received in a selected band of radio frequencies including the steps of frequency shifting signals by a frequency shift which varies as a function of time at a predetermined sweep rate and dispersively delaying signals over a range of time delay values as a function of frequency, characterised in that an incoming frequency band of signals is delayed by discrete amounts, the said frequency shifting step is performed on the resulting delayed signals to produce a plurality of variably delayed frequency swept representations of the signals, in that the signal representations are each subjected to the dispersively delaying step in accordance with a delay-frequency characteristic matched to the variation of the said frequency shift, and in that the dispersively delayed representations are frequency shifted and combined to produce an output which is a Fourier transformation of the incoming band of signals.

19. A method according to claim 17 or claim 18, characterised in that in-phase and quadrature components of the said output are derived for further processing.

# 0 032 276

**Patentansprüche**

1. Signalverarbeitungseinrichtung zum Analysieren eines Bandes von Eingangssignalen beispielsweise einer Radioempfängerschaltung, mit einer Frequenzverschiebungseinrichtung (43, 44), die eine sich als Funktion der Zeit ändernde Frequenzverschiebung liefert, und die einen frequenzvariablen Oszillator (44) mit vorbestimmter Wobbelgeschwindigkeit, der an einen Eingang eines ersten Mischers (43) angeschlossen ist, und eine dispergierende Verzögerungseinrichtung (45) zum Verzögern von Signalen in einem Bereich von Zeitverzögerungswerten als Funktion der Frequenz aufweist, dadurch gekennzeichnet, daß eine Verzögerungsleitung (31) mit mehreren Anzapfpunkten ($D_1 \ldots D_{k-1}$) vorgesehen ist, die einen Eingang zum Empfangen des Bandes von Eingangssignalen aufweist, daß ein Frequenzgenerator (37, 38 ...) vorgesehen ist, der für jeden der Anzapfpunkte einen Ausgang besitzt, von denen jeder ein Signal liefert, dessen Frequenz eine Funktion von (k—n)RT ist, wobei k—1 die Anzahl der Anzapfpunkte, R die Wobbelgeschwindigkeit des Oszillators (44), T eine Konstante und n die Nummer eines speziellen Anzapfpunkts ist, daß ein zweiter Mischer (34, 35 ...) das Ausgangssignal jedes Anzapfpunkts mit dem entsprechenden Ausgang des Frequenzgenerators (37, 38 ...) mischt, um mehrere frequenzverschobene diskrete Darstellungen des Bandes von Eingangssignal zu liefern, daß eine Einrichtung (42) vorgesehen ist, zum Kombinieren der frequenzverschobenen Darstellungen, um einer Frequenzmultiplexbildung unterworfene und verzögerte Darstellungen zu erzeugen, daß der erste Mischer (43) das Ausgangssignal des frequenzvariablen Oszillators (44) mit dem Ausgangssignal der Kombiniereinrichtung mischt, daß an den Ausgang des Mischers (43) ein dispergierendes Filter (45) geschaltet ist, dessen Gruppenlaufzeit-Kennlinie an die zeitliche Änderungsgeschwindigkeit des frequenzvariablen Oszillators mit einem maximalen Verzögerungswert T angepaßt ist, und daß an den Ausgang (46) des Filters (45) eine Ausgangsschaltung (50—73) gekoppelt ist, so daß die Einrichtung eine Fouriertransformation der Eingangssignale entwickelt, bei der Amplituden- und Phaseninformation erhalten bleiben und eine Abfangwahrscheinlichkeit von 100% gegeben ist.

2. Signalverarbeitungseinrichtung zum Analysieren eines Bandes von Eingangssignalen von beispielsweise einer Radioempfängerschaltung, mit einer Frequenzverschiebungseinrichtung (132—135, 144), die eine sich als Funktion der Zeit ändernde Frequenzverschiebung liefert, und die einen frequenzvariablen Oszillator (144) mit vorbestimmter Abtastgeschwindigkeit, welcher an einen Eingang eines ersten Mischers (132—135) angeschlossen ist, und eine dispergierende Verzögerungseinrichtung (101—104) zum Verzögern von Signalen in einem Bereich von Zeitverzögerungswerten als Funktion der Frequenz aufweist, dadurch gekennzeichnet, daß eine angezapfte Verzögerungsleitung (131a, 131b ...) vorgesehen ist, deren Eingang das Band von Eingangssignalen empfängt, daß der erste Mischer (132—135) die Signale an den Anzapfpunkten der Verzögerungsleitung mit einem Ausgangssignal der Oszillators (144) mischt, um mehrere veränderlich verzögerte Darstellungen der Signale zu erzeugen, daß die dispergierende Verzögerungseinrichtung mehrere dispergierende Verzögerungsleitungen (101—104) aufweist, von denen jede an den betreffenden Ausgang des ersten Mischers (132—135) angeschlossen ist und eine an die Frequenzänderungskennlinie des Oszillators (144) angepaßte Laufzeitkennlinie besitzt, daß ein Frequenzgenerator (105, 106, 107) mit mehreren Ausgängen vorgesehen ist, wobei jeder Ausgang ein Ausgangssignal einer zugehörigen Frequenz F=(k—n) RT liefert, wobei k—1 die Anzahl von Anzapfpunkten der angezapften Verzögerungsleitung (131a, 131b ...), n die Nummer des jeweiligen Anzapfpunkts, R die Abtastgeschwindigkeit des Oszillators (144) und T die maximale Verzögerung der dispergierenden Verzögerungsleitungen (101—104) ist, daß mehrere zweite Mischer (108, 109, 110) vorgesehen sind zum jeweiligen Kombinieren des Ausgangssignale des Frequenzgenerators (105, 106, 107) mit den Ausgangssignalen der Verzögerungsleitungen (101—104), die entsprechenden Anzapfpunkten der angezapften Verzögerungsleitung (131a, 131b ...) entspricht, und daß eine Einrichtung (111) vorgesehen ist zum Kombinieren der Ausgangssignale der Mischer (108, 109, 110).

3. Radioempfänger, gekennzeichnet durch eine Signalverarbeitungseinrichtung nach Anspruch 1 oder nach Anspruch 2, sowie ferner eine Eingangsschaltung (20—22) zum Empfangen eines Radiosignals, einem Empfängeroszillator (24) und einer Einrichtung (23) zum Mischen eines in der Eingangsschaltung empfangenen Radiosignals mit mindestens einer Frequenz des Empfängeroszillators, um ein Zwischenfrequenzprodukt zu erzeugen, das der Signalverarbeitungseinrichtung zugeführt wird.

4. Signalverarbeitungseinrichtung nach Anspruch 1, dadurch gekennzeichnet, daß das Filter (45) mehrere lineare Zeit-Frequenz-Abschnitte aufweist.

5. Einrichtung nach Anspruch 4, dadurch gekennzeichnet, daß jede der Frequenzen der Abschnitte um die Mittenfrequenz des von der Kombiniereinrichtung erzeugten Produkts zentriert ist.

6. Einrichtung nach Anspruch 1, 4 oder 5, gekennzeichnet durch eine an den Ausgang des Filters (45) angeschlossene ersten und zweite Einrichtung (50, 51) zum Ableiten von Quadraturkomponenten des Ausgangssignals des Filters.

7. Einrichtung nach Anspruch 6, gekennzeichnet durch eine Einrichtung (54, 55) zum Demodulieren der Ausgangssignale der ersten und der zweiten Quadraturkomponenten-Ableiteinrichtung (50, 51) und einer Einrichtung (56) zum Addieren des Ausgangssignals der Demoduliereinrichtung zwecks Erzeugung einer Nachbildung von empfangenen Analogsignalen.

16

**0 032 276**

8. Einrichtung nach einem der Ansprüche 1 und 4 bis 7, dadurch gekennzeichnet, daß die Kombiniereinrichtung (42, 111) ein Addierer ist.

9. Einrichtung nach einem der Ansprüche 1 und 4 bis 8, dadurch gekennzeichnet, daß der frequenzvariable Oszillator (44, 144) ein Empfängeroszillator mit linearer Wobbelung ist.

10. Einrichtung nach einem der Ansprüche 1 und 4 bis 9, gekennzeichnet durch eine Einrichtung (26) zum Triggern des frequenzvariablen Oszillators (44, 144) jeweils einmal bei jeder von mehreren Wobbelperioden.

11. Einrichtung nach Anspruch 6, dadurch gekennzeichnet, daß die Ausgangsschaltung enthält:

— einen ersten und einen zweiten Analog/Digital-Umsetzer (70, 71), die an die Ausgänge der jeweiligen Quadraturkomponenten-Ableiteinrichtung (50, 51) angeschlossen sind,

— eine an die Ausgänge der Analog/Digital-Umsetzer (70, 71) angeschlossene Schalteinrichtung (72, 73), und

— eine Zeitgebereinrichtung (25), die an den frequenzvariablen Oszillator (44) angeschlossen ist, um dessen Frequenzänderung zu triggern, und die an die Schalteinrichtung (72, 73) angeschlossen ist, um diese zu einer Zeit leitend zu machen, die Beziehung steht zu einer ausgewählten Frequenz des frequenzvariablen Oszillators (44).

12. Einrichtung nach Anspruch 11, dadurch gekennzeichnet, daß der frequenzvariable Oszillator (44) ein linearer Wobbeloszillator ist, und daß die Zeitgebereinrichtung (25) die Schalteinrichtung (72, 73) zu einer Zeit nach Beginn der Wobbelung des linearen Wobbeloszillators freigibt, die zu der benötigten zu verarbeitenden Frequenz in Beziehung steht.

13. Einrichtung nach Anspruch 11 oder 12, gekennzeichnet durch eine individuelle Schalteinrichtung (72, 73) für jede der Quadraturkomponenten-Ableiteinrichtungen (50, 51).

14. Einrichtung nach Anspruch 6, 11, 12 oder 13, gekennzeichnet, durch ein Paar an die jeweiligen Quadraturkomponenten-Ableiteinrichtungen (50, 51) angeschlossene quadratische Detektoren (54, 55) zum Erfassen zweier orthogonaler Signalkomponenten, und einer Einrichtung (56) zum Addieren der erfaßten Komponenten, um ein Zeit-Amplituden-Spektrum des Signalbands am Eingang der Einrichtung zu rekonstruieren.

15. Einrichtung nach Anspruch 6, dadurch gekennzeichnet, daß die Ausgangsschaltung ein Paar jeweils an die Quadraturkomponenten-Ableiteinrichtungen (50, 51) angeschlossene Signaldetektoren (54, 55) und ein Einrichtung (56) zum Kombinieren der Ausgangssignale dieser Detektoren aufweist.

16. Einrichtung nach Anspruch 15, dadurch gekennzeichnet, daß die Kombiniereinrichtung (56) ein Addierer ist.

17. Verfahren zum Verarbeiten von in einem ausgewählten Band von Radiofrequenzen liegenden Signalen, bei dem Signale in ihrer Frequenz durch eine Frequenzverschiebung verschoben werden, die sich als Funktion der Zeit mit einer vorbestimmten Wobbelgeschwindigkeit ändert, und Signale in einem Bereich von Zeitverzögerungswerten als Funktion der Frequenz dispergierend verzögert werden, dadurch gekennzeichnet, daß ein ankommendes Frequenzband von Signalen um diskrete Beträge verzögert wird, daß die Frequenzverschiebung als Funktion der Zeit mit jeder der sich ergebenden verzögerten Darstellungen durchgeführt wird, und daß die verzögerten und frequenzverschobenen Darstellungen kombiniert und der dispergierenden Verzögerung nach Maßgabe einer Laufzeitkennlinie unterworfen werden, die an die Änderung der Frequenzverschiebung angepaßt ist, um ein Ausgangssignal zu erhalten, welches eine Fouriertransformation des ankommenden Signalbandes ist.

18. Verfahren zum Verarbeiten von in einem ausgewählten Band von Radiofrequenzen empfangenen Signalen, bei dem Signale durch eine Frequenzverschiebung in ihrer Frequenz verschoben werden, die sich als Funktion der Zeit mit einer vorbestimmten Wobbelgeschwindigkeit ändert, und Signale dispergierend in einem Bereich von Zeitverzögerungswerten als Funktion der Frequenz verzögert werden, dadurch gekennzeichnet, daß ein ankommendes Frequenzband von Signalen um diskrete Beträge verzögert wird, daß die Frequenzverschiebung mit den sich ergebenden verzögerten Signalen durchgeführt wird, um mehrere veränderlich verzögerte, in der Frequenz gewobbelte Darstellungen der Signale zu erzeugen, daß die Signaldarstellungen jeweils bei der dispergierenden Verzögerung nach Maßgabe einer Laufzeitkennlinie verzögert werden, die an die Änderung der Frequenzverschiebung angepaßt ist, und daß die dispergierend verzögerten Darstellungen frequenzverschoben und kombiniert werden, um ein Ausgangssignal zu erzeugen, welches einer Fouriertransformation des ankommenden Bandes von Signalen ist.

19. Verfahren nach Anspruch 17 oder 18, dadurch gekennzeichnet, daß die phasengleichen und die Quadraturkomponenten des Ausgangssignals zur weiteren Verarbeitung abgeleitet werden.

**Revendications**

1. Appareil de traitement de signal pour analyser une bande de signaux d'entrée provenant, par exemple, d'un circuit de récepteur radio, l'appareil comprenant des moyens de décalage de fréquence (43, 44) effectuant un décalage de fréquence qui varie en fonction du temps, lesdits moyens de décalage de fréquence comprenant un générateur d'oscillations à fréquence variable (44) ayant un taux

**0 032 276**

de balayage prédéterminé relié à une entrée de premiers moyens mélangeurs (43), et des moyens de retard dispersif (45) pour retarder les signaux sur un domaine de valeurs de retard temporel en fonction de la fréquence, l'appareil étant caractérisé par:

une ligne à retard (31) comportant plusieurs prises ($D_1 \ldots D_{K-1}$), ayant une entrée destinée à recevoir la bande de signaux d'entrée; des moyens générateurs de fréquence (37, 38...) ayant une sortie particulière pour chacune des prises, chaque sortie fournissant un signal ayant une fréquence qui est fonction de (k—n) RT ou k—1 est le nombre de prises, R est le taux de balayage du générateur d'oscillations (44), T est une constante et n est le numéro d'une prise particulière; des seconds moyens mélangeurs (34, 35) pour mélanger la sortie de chaque prise avec la sortie correspondante des moyens de génération de fréquence (37, 38...) pour fournir plusieurs représentations discrètes décalées en fréquence de la bande de signaux d'entrée; des moyens (42) pour combiner les représentations décalées en fréquence de façon à produire des représentations multiplexées en fréquence et retardées; les premiers moyens mélangeurs (43) mélangeant la sortie du générateur d'oscillations à fréquence variable (44) et la sortie des moyens de combinaison; des moyens de filtrate dispersif (45) couplés à la sortie des moyens mélangeurs (43), ayant une caractéristique retard fréquence adaptée au taux de variation temporelle du générateur d'oscillations à fréquence variable, avec une valeur de retard maximum T; et un circuit de sortie (50—73) couplé à la sortie (46) des moyens de filtrage (45), de sorte que l'appareil effectue une transformation de Fourier sur les signaux d'entrée en préservant l'information en amplitude et en phase avec une probabilité d'interception de 100%.

2. Appareil de traitement de signal pour analyser une bande de signaux d'entrée tels que par exemple ceux provenant d'un circuit de récepteur radio, ledit appareil comprenant des moyens de décalage de fréquence (132—135, 144) fournissant un décalage de fréquence qui varie en fonction du temps, lesdits moyens de décalage de fréquence comprenant un générateur d'oscillations à fréquence variable (144) ayant un taux de balayage prédéterminé qui est relié à une entrée de premiers moyens mélangeurs (132—135), et des moyens de retard dispersif (101—104) pour retarder les signaux sur un domaine de valeurs de retard temporel en fonction de la fréquence, ledit appareil de traitement de signal étant caractérisé par:

une ligne à retard à prises (131a, 131b...) ayant une entrée destinée à recevoir la bande de signaux d'entrée; lesdits premiers moyens mélangeurs (132—135) mélangeant les signaux prélevés aux prises de la ligne à retard avec un signal de sortie du générateur d'oscillations (144) pour produire plusieurs représentations des signaux ayant un retard variable, lesdits moyens de retard dispersif comprenant plusieurs lignes à retard dispersives (101—104) dont chacune est couplée respectivement à une sortie des premiers moyens mélangeurs (135) et dont chacune a une caractéristique fréquence-retard adaptée aux caractéristiques de variation de fréquence du générateur d'oscillations (144); des moyens générateurs de fréquence (105, 106, 107) ayant plusieurs sorties, chaque sortie fournissant un signal de sortie respectif à fréquence respective F=(k—n) RT, où k—1 est le nombre de prises de la ligne à retard à prises (131a, 131b...), n est le numéro d'une prise particulière, R est le taux de balayage du générateur d'oscillations (144) et T est le retard maximum des lignes à retard dispersives (101—104); plusieurs seconds moyens mélangeurs (108, 109, 110) pour combiner respectivement les signaux de sortie des moyens générateurs de fréquence (105, 106, 107) avec les signaux de sortie des lignes à retard (101—104) correspondant à des prises respectives de la ligne à retard à prises (131a, 131b...); et des moyens (111) pour combiner les sorties des mélangeurs (108, 109, 110).

3. Récepteur radio comprenant la combinaison d'un appareil de traitement de signal suivant la revendication 1 ou la revendication 2 et d'un circuit d'entrée (20—22) destiné à recevoir un signal radio, un oscillateur local (24) et des moyens (23) pour mélanger un signal radio reçu dans le circuit d'entrée avec au moins une fréquence d'oscillateur local pour produire un produit à fréquence intermédiaire destiné à alimenter l'appareil de traitement de signal.

4. Appareil de traitement de signal suivant la revendication 1, caractérisé en ce que les moyens de filtrage (45) ont plusieurs tronçons à caractéristique linéaire temps-fréquence.

5. Appareil suivant la revendication 4, caractérisé en ce que chacune des fréquences des tronçons est centrée par rapport à la fréquence centrale du produit provenant des moyens de combinaison.

6. Appareil suivant la revendication 1, la revendication 4 ou la revendication 5, caractérisé par des premiers et seconds moyens (50, 51) couplés à la sortie des moyens de filtrage (45) pour extraire les composantes en quadrature du signal de sortie des moyens de filtrage.

7. Appareil suivant la revendication 6, caractérisé par des moyens (54, 55) pour détecter les sorties des premiers et seconds moyens (50, 51) d'extraction de composante en quadrature; et des moyens (56) pour faire la somme de la sortie des moyens de détection afin de réaliser une reconstruction des signaux analogiques reçus.

8. Appareil suivant l'une quelconque des revendications 1 et 4 à 7, caractérisé en ce que les moyens de combinaison (42, 111) sont constitués par un additionneur.

9. Appareil suivant l'une quelconque des revendications 1 et 4 à 8, caractérisé en ce que le générateur d-oscillations à fréquence variable (44, 144) est un oscillateur local à balayage linéaire.

10. Appareil suivant l'une quelconque des revendications 1 et 4 à 9, caractérisé par des moyens (26) pour déclencher ledit générateur d'oscillations à fréquence variable (44, 144) une fois chacune de plusieurs périodes de balayage.

11. Appareil selon la revendication 6, caractérisé en ce que le circuit de sortie comprend:

des premiers et des seconds convertisseurs analogique/numérique (70, 71) couplés aux sorties de moyens respectifs (50, 51) d'extraction de composantes en quadrature;

des moyens de commutation (72, 73) couplés aux sorties des convertisseurs analogique/numérique (70, 71); et

des moyens de temporisation (25) couplés au générateur d'oscillations à fréquence variable (44) pour déclencher sa variation de fréquence et couplés aux moyens de commutation (72, 73) pour amener lesdits moyens de commutation à un état conducteur à un instant relié à une fréquence sélectionnée de générateur d'oscillations à fréquence variable (44).

12. Appareil selon la revendication 11, caractérisé en ce que le générateur d'oscillations à fréquence variable (44) est un oscillateur à balayage linéaire et en ce que les moyens de temporisation (25) de bloquent les moyens de commutation (72, 73) au bout d'un temps, après le début de balayage de l'oscillateur à balayage linéaire, qui est rattaché à la fréquence requise à traiter.

13. Appareil suivant la revendication 11 ou la revendication 12, caractérisé par des moyens commutateurs individuels (72, 73) pour chacun des moyens (50, 51) d'extraction de composante en quadrature.

14. Appareil selon la revendication 6, la revendication 11, la revendication 12 ou la revendication 13, caractérisé par une paire de détecteurs à loi quadratique (54, 55) couplés auxdits moyens (50, 51) d'extraction de composante en quadrature pour détecter deux composantes orthogonales des signaux; et

des moyens (56) pour sommer lesdites composantes détectées de façon à reconstituer un spectre temps-amplitude de la bande de signal à l'entrée de l'appareil.

15. Appareil selon la revendication 6, caractérisé en ce que le circuit de sortie comprend une paire de détecteurs de signal (54, 55) couplés respectivement aux moyens (50, 51) d'extraction de composante un quadrature et des moyens (56) pour combiner la sortie des détecteurs.

16. Appareil selon la revendication 15, caractérisé en ce que les moyens de combinaison (56) sont constitués par un additionneur.

17. Méthode de traitement de signaux reçus dans une bande sélectionnée de radio-fréquences, comportant les étapes consistant à décaler en fréquence les signaux, d'un décalage de fréquence qui varien en fonction du temps, avec un taux de balayage prédéterminé, et à imposer un retard dispersif aux signaux sur un domaine de retard temporel fonction de la fréquence, caractérisée en ce qu'une bande de fréquence d'entrée de signaux est retardée par quantités discrètes, en ce que l'étape de décalage de fréquence est réalisée sur chacune des représentations retardées résultantes en fonction du temps, et en ce que les représentations retardées et décalées en fréquence sont combinées et soumises à l'étape de retard dispersif suivant une caractéristique retard-fréquence qui est adaptée à la variation de décalage en fréquence de façon à fournir une sortie qui est une transformée de Fourier de la bande de signaux d'entrée.

18. Procédé de traitement de signaux reçus dans une bande sélectionnée de radio-fréquences, comportant les étapes consistant à décaler en fréquence les signaux d'un décalage de fréquence qui varie en fonction du temps avec un taux de balayage prédéterminé et à imposer un retard dispersif aux signaux sur un domaine de retard temporel fonction de la fréquence, caractérisée en ce que l'on retarde une bande de fréquence de signaux d'entrée de quantités discrètes, en ce qu'on exécute l'étape de décalage en fréquence sur les signaux retardés qui en résultent de façon à produire plusieurs représentations des signaux, avec balayage en fréquence et retard variable, en ce que l'on soumet chacune des représentations de signal à l'étape de retard dispersif suivant une caractéristique retard-fréquence adaptée à la variation dudit décalage de fréquence, et en ce que l'on décale en fréquence et en ce que l'on combine les représentations à retard dispersif de façon à fournir une sortie qui est une transformée de Fourier de la bande de signaux d'entrée.

19. Méthode selon la revendication 17 ou la revendication 18, caractérisée en ce que l'on extrait les composantes en phase et un quadrature de ladite sortie pour traitement complémentaire.

**0 032 276**

PRIOR ART

Fig.1.

Fig.2.

PRIOR ART

$V(t)$

Fig.3.

PRIOR ART

$B$

$B_{IF}$

$0$    $T$    $T_S$    $T_S + T$

1

FIG. 4

FIG. 5

FIG. 6

FIG. 7

## FIG. 8

$$S(\omega) = S_O(\omega - \omega_c) + S_O(-\omega - \omega_c)$$

$$S_O(\omega)$$

$BW = 2\pi B$

$S_O(-\omega - \omega_c)$

$S_O(\omega - \omega_c)$

$-\omega_c$    O    $\omega_c$

O

## FIG. 9

$\dfrac{\Delta f}{B/TW}$

$\overline{B\Delta f} \qquad \overline{B}$

K=8, K=7, K=6, K=5, K=4, K=3, K=2, K=1

## FIG. 10

| T | T+1 | ⋯ | $T_S$ | $T_S+1$ | ⋯ | 2T | 2T+1 | ⋯ | $T_S+T$ | $T_S+T+1$ | ⋯ |

| 0 | 1 | ⋯ | $T_S-T$ | $T_S-T-1$ | ⋯ | T | T+1 | ⋯ | $T_S$ | $T_S+1$ | ⋯ |

$F_O$

#1    #2 ⟶ ⋯

B R

O      T      2T      $T_S$

## FIG. 11

FIG. 14

FIG. 13

FIG. 12

FIG. 15

FIG. 16

FIG. 17

7